# EUROPEAN PATENT SPECIFICATION

(11) **EP 2 290 716 B1**
(45) Date of publication and mention of the grant of the patent: **12.06.2019**
(21) Application number: 10184330.8
(22) Date of filing: 16.10.2007
(51) Int. Cl.: H01L 33/50, H01L 33/56, H01L 33/60

(54) **LED module**
LED-Modul
Module à DEL

(30) Priority: 20.10.2006 EP 06022064
(43) Date of publication of application: 02.03.2011
(62) Divisional of application: 07819030.3
(73) Proprietor: Tridonic Jennersdorf GmbH, 8380 Jennersdorf (AT); Lumitech Patentverwertung GmbH, 8380 Jennersdorf (AT)
(72) Inventor: Schrank, Franz, 8047, Raab (AT); Hoschopf, Hans, 8380, Jennersdorf (AT)
(74) Representative: Rupp, Christian

(56) References cited:
- EP-A1- 1 641 050
- EP-A2- 0 854 523
- EP-A2- 1 059 678
- WO-A1-2007/018560
- WO-A2-2005/117071
- DE-C1- 10 245 946
- JP-A- 2006 066 786
- US-A- 5 851 847
- US-A1- 2003 173 655

## Description

The present invention relates to the field of light emitting diode (LED) modules comprising a LED chip mounted on a board, and a cover. The cover is designed to allow the directed passage of light from the LED chip.

From the state of the art it is known to cover so called COB (chip-on-board) LED modules with a so called globe-top which is based on a heat-curable resin. Such a globe-top is usually applied with standard dispensing equipment. However, the performance of LED modules having such a globe-top is not satisfying all requirements of different application fields. One of the main disadvantages actually is the directive characteristics, i.e. the wide emission angle, which is not well suited for using such a LED module with secondary optics, such as for example lenses or light guides.

In order to have a smaller emission angle of the light emitted by COB LED modules the LED chip is sometimes placed in a cavity with a reflecting wall. However, due to the spherical shape of the top surface of the globe-top, the contribution of the reflecting wall on the emission angle is not satisfying.

The second disadvantage of the globe-top cover is the low mechanical stability of the LED modules which is a disadvantage for the handling and mounting of the LED modules. In this context is to be noted that based on the requirements on a high UV stability, usually silicones are used as resins for the globe-top. Unfortunately, these rubber-like materials apply a high mechanical stress to bond wires if the spherical shape of the globe-top is warped.

WO 2006/017484A1 proposes a dam-and-fill technology in order to protect parts of a printed circuit board against electric short circuits.

DE 10245946 C1 discloses a LED module comprising a LED chip mounted on a board, a cured silicone resin dam comprising reflecting TiO₂ particles dispensed on the board, and a transparent cured resin filled into the dam. US 5,851,847 discloses a LED module comprising a LED chip mounted on a board, a cured silicone resin dam dispensed on the board, and a transparent cured silicone resin filled into the dam, wherein the silicone filling is chemically linked to the dam across the interface between the two materials. JP 2006-066786 discloses a LED module comprising a LED chip mounted on a board, a transparent cured silicone resin dam dispensed on the board, and a transparent cured silicone resin comprising colour conversion particles filled into the dam.

Therefore, it is the object of the present invention to propose an improved cover for LED modules which allows the directed passage of light from the LED chip.

This object is achieved by means of the features of independent claim 1. The dependent claims develop further the central idea of the present invention.

According to the present invention the over comprises an outer non-transparent and reflective dam and a central filling, which central filling has been filled into the outer dam preferably after the manufacturing of the outer dam. The outer dam and the central filling are respectively made from a cured silicone based resin and a cured transparent resin. The central filling is chemically linked to the outer dam across the interface between the two materials. Note that "outer dam" does not represent any limitation as to the shape, as long as the dam can act as a dam surrounding the central filling and being stable in shape even in the uncured state.

The resin of the central filling can be e.g. silicone.

The resin of the outer dam comprises reflecting particles which are white pigments. The reflecting particles are preferably present throughout the bulk of the outer dam material. The dam thus has the role of a reflector applied in the liquid state on a board.

The outer dam can comprise 10 to 60 weight % of the reflecting particles.

The resin of the outer dam and the central filling can have the same chemical structure, e.g. they can be chemically identical.

The resin of the outer dam can be selected to have a storage modulus of more than 1000 Pa before being cured.

The resin of the outer dam can be selected such that it has for example a viscosity of more than 100 Pa*s when measured at a shear rate of 1 1/s, again before being cured.

The material of the outer dam can comprise particulate material such as e.g. silica, which particular material or fine grained material can be used in order to set the desired rheological properties of the uncured dam resin.

The height of the outer dam can be equal to or more than 1mm.

The mean thickness of the outer dam can be selected according to the requirements of the final element. For a diameter of approx. 5 mm the thickness can be equal to or less than 0.5mm. For larger diameters the thickness is adjusted to more than 0.5 mm, for smaller diameters the thickness might be less than 0.5 mm.

The inner diameter of the dam can be as small as e.g. 0.1 to 1mm.

The cover comprises an outer dam and a central filling, which has been filled into the outer dam and at least partially on top of the LED chip after the outer dam has been made on the board surrounding the LED chip.

The central filling is made from a cured transparent resin, such as e.g. silicone.

The central filling comprises color conversion particles which convert light emitted from the LED chip into light of a second, lower frequency spectrum.

The inner wall of the outer dam can be distanced from the LED chip, such that the distance between the outer dam and the LED chip is filled with the central filling which thus is also in contact with the board on which the LED chip is mounted e.g. in a chip-on-board technology.

The central filling can fill the entire volume defined by the outer dam such that the top surface of the filling is on the same level as the maximum height of the outer dam.

Preferably the outer dam is raised higher from the board than the LED-chip.

In a method for manufacturing a LED module, not forming part of the present invention, an outer dam made from a liquid resin is first dispensed. This outer dam is then filled with a liquid resin. Finally, in one single step, the resin of the outer dam and the resin of the central filling are cured and a chemically linked interface between the outer dam and the central filling is provided which guarantees a stronger adhesion between the central filling and the outer dam.

Further aspects, advantages and objects of the present invention will become evident from the following detailed explanation of embodiments of the present invention when taking in conjunction with the figures of the enclosed drawings.
Fig. 1 shows schematically a side view of a LED module having a cover according to the present invention.
Fig. 2 shows a top view of a LED module with a cover according to the present invention.
Fig. 3 shows a perspective view of a cover used in the LED module of the present invention.
Fig. 4 shows the use of a cover together with a light-erasable storage device, not forming part of the present invention, and
Fig. 5 shows the use of the LED module of the present invention in connection with a light guiding element.

To start with, a method for manufacturing a LED module, not forming part of the present invention will be explained.

As the cover has a role a optical element, its precision has to go far beyond the precision necessary for purely protective purposes as known from WO 2006/017484A1.

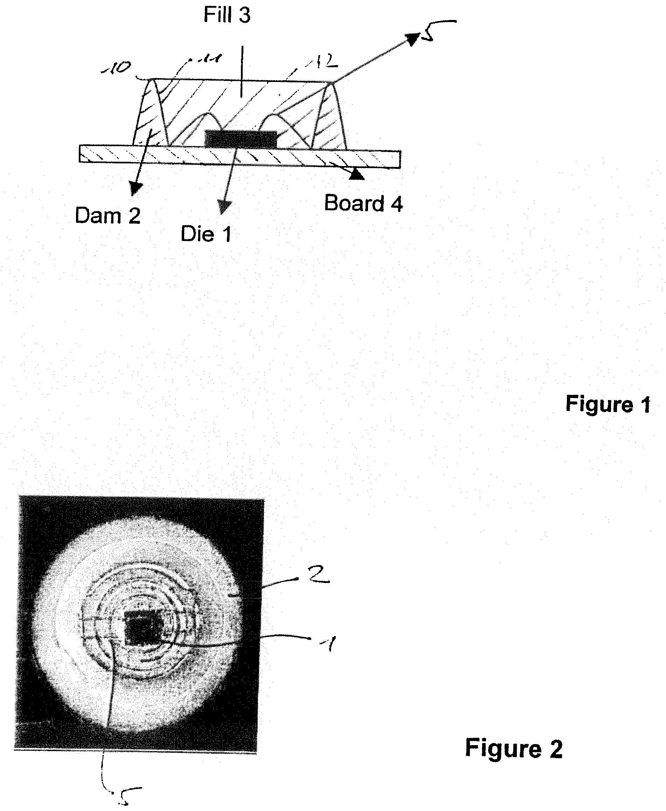

The following method will be explained in the context of producing a LED module as shown in Fig. 1.

In a first step, a ring-shaped dam (torus) of a liquid resin is dispensed around the LED chip 1, which is mounted on a board 4.

Preferably a plane board without recessions is used, as the reflective effect of walls of a recession can be achieved by the dam walls.

Dispensing techniques for resins and silicones are known as such from the prior art. Due to the dispensing technique the cross-sectional view of the dam tapers to the peak 10 of the dam 2. Thus the inner face 11 of dam 2 is inclined and preferably is steeper at its upper part which can be of advantage for reflection purposes.

The cross-sectional shape of the dam 2 can be controlled by the diameter of the dispensing needle used, the flow characteristics of the liquid dam material and the flow (dispensing) speed.

In the example shown in Fig. 1 the LED chip 1 is mounted according to the chip-on-board (COB) technology. The bond wires are designated with the reference numeral 5.

The wall of liquid resin is dispensed on the board 4 around the LED die 1 thus forming a dam.

The dam material is non-transparent for the wavelength of the light passing through the central filling inside the dam.

Please note that "outer dam" in the context of the present description and claims does not constitute any limitation as to the contour of the walls, i.e. the dam does not necessarily have a spherical shape, but can e.g. have the shape of a square, an oval, a rectangular shape etc..

The circular shape is preferred if only a single LED chip is placed inside the dam (see later on), while a rectangular or oval shape is preferred in case a plurality of LED chips are placed inside the dam in a row configuration.

Different silicone based resins can be used for the dam 2. Silicone materials are known for their high UV stability.

The rheological characteristics of the liquid resin material for building the wall of the dam 2 have to be well selected such that after the dispensing the uncured resin is stable in shape until it is cured.

To this regard the storage modulus should be rather high and e.g. be at least 1000 Pa. The loss factor should be approximately 0.5.

The viscosity of the liquid resin should preferably be higher than 200 Pa*s (when measured at a shear rate of 1 1/s). A liquid resin material of such characteristics is suited for achieving a wall e.g. with a height of more than 1mm and a mean thickness of less than 0.5mm.

In order to adjust the rheological characteristics of the liquid resin material, silica or other particulate material (fine grained material) can be added to the liquid resin.

As can be seen from Fig. 1, preferably the wall 2 is distanced from the LED die 1.

Furthermore, the height of the dam 2 is set to be higher than the height of the LED die 1. E.g. the height of the dam 2 can be twice or three times the height of the LED die 1.

In order to obtain a higher light reflectivity of the wall of the dam 2, reflecting white pigments made from TiO₂, BaTiO₃, BaSO₄ and/or ZrO₂ are added into the liquid resin.

Preferably, these pigments are added to the liquid resin in an amount of 10% to 60% per weight.

Thus the entire material of the dam will have a non-transparent and white reflecting appearance. The reflection from light from the LED die 1 occurs at the inner face 11 of the dam 2 reflecting light back to the interior of the dam 2 and away from the LED die 1.

In a second step of the manufacturing process the volume confined by the inner walls of the self-stable dam 2 is filled with a liquid filling material. As can be seen from Fig. 1, this filling is preferably made such that the top level of the filling flushes with the top level of the walls of the dam 2. Due to the filling with the liquid resin the top surface 12 of the central filling 3 will be preferably flat.

To summarize, liquid uncured resin is filled in a cavity defined by a self-stable dam of uncured resin, which preferably chemically identical, but can be different regarding optical and mechanical characteristics (as the material of the outer dam 2 and is provided with different "additives" as the material of the central filling 3).

The chemical identity has to be such that the material used for the dam and the filling, respectively, can be cured using the same curing mechanism in order to produce a chemical linking across the interface between the two materials.

The filling material entirely covers the top surface of the LED die 1. It also covers the space between the LED die 1 and the walls of the dam 2 (if any) and contacts the board 4 in this gap between the LED die 1 and the dam 2.

The transparent material for the central filling 3 is also a resin and can be e.g. be made from a silicone material.

Preferably, the resin for the central filling 3 is made from the same material as the resin for the dam 2 such that these resins are chemically identical.

In accordance with the present invention, white color-conversion LED modules are provided, in which colour conversion particles are added to the fill material of the central filling 3. The type and the amount of the colour conversion particles depends on the desired colour temperature of the LED module, which is known as such from the prior art. Preferably there is an increasing concentration gradient of the color conversion particles from the top to the bottom of the filling, which can be achieved e.g. by allowing the color conversion particles to sink towards the bottom of the filling.

In a third step the liquid resins i.e. the resins of the central filling 3 and the dam 2 are cured. By a single curing cycle both of the materials can be cured and chemically linked together at their interface.

The above-outlined manufacturing process relies on a relatively high mechanical stability of the material of the wall in the uncured "liquid" state. Again, in order to achieve this mechanical stability in the liquid state, additional filling materials such as for example silica can be added to the resin for the dam 2.

Both for the manufacturing of the dam 2 as well as for the filling a standard computer controlled dispensing equipment can be used.

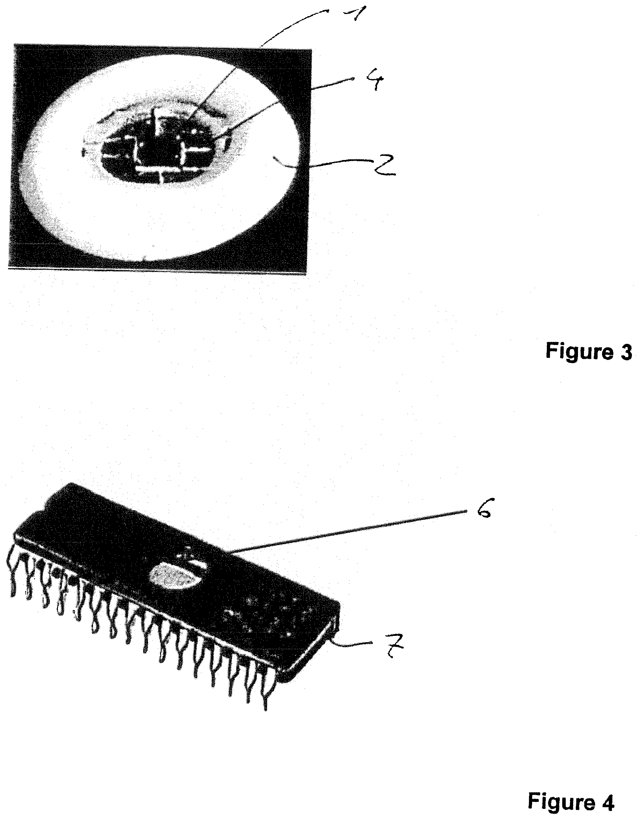

Figures 2 and 3 show a top view (Fig. 2) and a perspective view (Fig. 3) of a LED module according to the present invention comprising a LED chip mounted in chip-on-board technology. In these LED modules the material of the dam 2 is highly reflective as white pigments have been added throughout the base resin for the dam 2. On the other hand, the resin for the filling 3 is transparent and the bond wires 5 can be seen which are surrounded and stabilized by the material of the central filling 3.

In Fig. 4 a light-erasable memory device such as for example an EEPROM 7, not forming part of the present invention, is shown.

The cover can protect the opening 6 of the casing of the light erasable memory device 7, which opening is designed for the light erasing process.

Due to the "dam-and-fill" cover, which can be made of highly transparent materials depending on the requirements of the erasing/programming light beam, a protection against environmental influences as well as perfect fit to the erasing/programming light source can be achieved. Especially, the protection against scattered light and stray light is a big advantage of the dam and fill cover. The outer dam thus can not only serve as a reflective element, but additionally or alternatively as an opaque shielding.

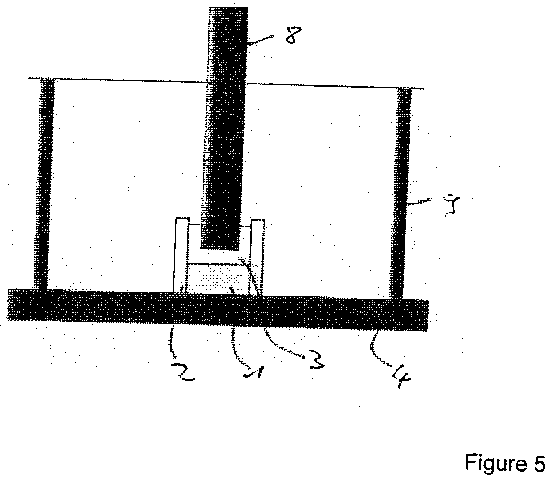

Finally, Fig. 5 shows the use of a LED module according to the present invention in connection with light guides and optical fibers.

The dam material 2 provides a mechanical stability, such that it is possible to provide the filling 3 on top of the light source as a very fluid and highly transparent synthetic resin.

In the example shown in Fig. 5 there is no gap between the dam 2 and the LED chip 1 such that the filling material is only present on top of the LED chip 1.

Furthermore, the filling 3 is not completely flush with the top of the wall of the dam 2.

The reference sign 8 designates an optical fiber to which light from the LED chip 1 is to be transmitted (transversing the fill material 3).

The reference sign 9 designates mechanical fixture for optical fibers.

The arrangement as shown in Fig. 5 provides for an improved light feeding from the LED chip to the optical fibre.

## Claims

1. A LED module comprising a LED chip (1) mounted on a board (4), and a cover,
- the cover comprising an outer dam (2) dispensed on the board, and
- a central filling (3), which is filled into the outer dam (2),
wherein the outer dam (2) is made from a cured silicone based resin,
wherein the central filling (3) is made from a cured transparent resin, and
wherein the central filling (3) comprises color conversion particles,
**characterised in that**
the outer dam (2) is non-transparent and comprises reflecting particles, which are white pigments made from TiO₂, BaTiO₃, BaSO₄ and/or ZrO₂, and
the central filling (3) is chemically linked to the outer dam (2) across the interface between the two materials.

2. The LED module according to Claim 1,
wherein the resin of the outer dam (2) and the central filling (3) have the same chemical structure.

3. The LED module according to Claim 1,
wherein the resin of the outer dam (2) and the central filling (3) are chemically identical.

4. The LED module according to any of the preceding claims,
wherein the outer dam (2) comprises 10 to 60 weight % of reflecting particles.

5. The LED module according to any of the preceding claims, wherein the LED chip (1) is mounted on the board (4) according to a chip-on-board technology.

6. The LED module according to any of the preceding claims,
wherein the inner wall of the outer dam (2) is distanced from the LED chip (1), the distance between the outer dam (2) and the LED chip (1) being filled with the central filling (3).

7. The LED module according to any of the preceding claims, wherein the central filling (3) fills the entire volume defined by the outer dam (2).

8. The LED module according to any of the preceding claims,
wherein the outer dam (2) is higher than the LED chip (1).

9. The LED module according to any of the preceding claims,
wherein the height of the outer dam (2) has at least the height of LED chip (1) to be covered.

10. The LED module according to any of the preceding claims,
wherein the outer dam (2) has circular, oval, or rectangular shape.

11. The LED module according to any of the preceding claims, comprising a plurality of LED chips (1), wherein the LED chips (1) are in a row configuration placed inside the outer dam (2).

12. The LED module according to any of the preceding claims,
wherein the central filling (3) is dispensed into the outer dam (2).

13. The LED module according to any of the preceding claims, comprising bonding wires (5),
wherein the bonding wires (5) are surrounded and stabilized by the material of the central filling (3).

14. The LED module according to any of the preceding claims,
wherein the board (4) is a plane board (4) without recessions.

15. The LED module according to any of the preceding claims,
wherein the cross-section of the outer dam (2) tapers to the peak (10) of the outer dam (2) and wherein the inner face (11) of the outer dam (2) is inclined.

16. The LED module according to claim 15,
wherein the inner face (11) of the outer dam (2) is steeper at its upper part.

17. The LED module according to any of the preceding claims,
wherein the outer dam (2) comprises silica particles.

## Patentansprüche

1. LED-Modul, umfassend einen LED-Chip (1), der auf einer Platine (4) montiert ist, und eine Abdeckung,
- die Abdeckung umfassend einen äußeren Damm (2), der auf der
Platine verteilt ist, und
- eine mittige Füllung (3), die in den äußeren Damm (2) gefüllt ist,
wobei der äußere Damm (2) aus einem gehärteten Harz auf Silikonbasis besteht,
wobei die mittige Füllung (3) aus einem gehärteten transparenten Harz besteht, und
wobei die mittige Füllung (3) Partikel zur Farbkonvertierung umfasst, **dadurch gekennzeichnet, dass** der äußere Damm (2) nicht transparent ist und reflektierende Partikel umfasst, bei denen es sich um weiße Pigmente handelt, die aus TiO₂, BaTiO₃, BaSO₄ und/oder ZrO₂ bestehen, und
wobei die mittige Füllung (3) mit dem äußeren Damm (2) über die Grenzfläche zwischen den beiden Materialien chemisch verbunden ist.

2. LED-Modul nach Anspruch 1,
wobei das Harz des äußeren Damms (2) und die mittige Füllung (3) die gleiche chemische Struktur aufweisen.

3. LED-Modul nach Anspruch 1,
wobei das Harz des äußeren Damms (2) und die mittige Füllung (3) chemisch identisch sind.

4. LED-Modul nach einem der vorhergehenden Ansprüche,
wobei der äußere Damm (2) 10 bis 60 Gew.-% reflektierender Partikel aufweist.

5. LED-Modul nach einem der vorhergehenden Ansprüche, wobei der LED-Chip gemäß einer Chip-on-Board-Technik auf der Platine (4) montiert ist.

6. LED-Modul nach einem der vorhergehenden Ansprüche,
wobei die Innenwand des äußeren Damms (2) von dem LED-Chip (1) beabstandet ist, wobei der Abstand zwischen dem äußeren Damm (2) und dem LED-Chip (1) mit der mittigen Füllung (3) gefüllt ist.

7. LED-Modul nach einem der vorhergehenden Ansprüche, wobei die mittige Füllung (3) das gesamte, durch den äußeren Damm (2) definierte Volumen füllt.

8. LED-Modul nach einem der vorhergehenden Ansprüche, wobei der äußere Damm (2) höher als der LED-Chip (1) ist.

9. LED-Modul nach einem der vorhergehenden Ansprüche, wobei die Höhe des äußeren Damms (2) zumindest die Höhe des zu bedeckenden LED-Chips (1) aufweist.

10. LED-Modul nach einem der vorhergehenden Ansprüche, wobei der äußere Damm (2) eine kreisförmige, ovale oder rechteckige Form aufweist.

11. LED-Modul nach einem der vorhergehenden Ansprüche, umfassend eine Vielzahl von LED-Chips (1),
wobei die LED-Chips (1) in einer Reihenanordnung innerhalb des äußeren Damms (2) angeordnet sind.

12. LED-Modul nach einem der vorhergehenden Ansprüche,
wobei die mittige Füllung (3) in dem äußeren Damm (2) verteilt ist.

13. LED-Modul nach einem der vorhergehenden Ansprüche, umfassend Bonddrähte (5),
wobei die Bonddrähte (5) von dem Material der mittigen Füllung (3) umgeben und dadurch stabilisiert sind.

14. LED-Modul nach einem der vorhergehenden Ansprüche,
wobei die Platine (4) eine ebene Platine (4) ohne Aussparungen ist.

15. LED-Modul nach einem der vorhergehenden Ansprüche,
wobei sich der Querschnitt des äußeren Damms (2) zu der Spitze (10) des äußeren Damms (2) hin verjüngt, und
wobei die Innenfläche (11) des äußeren Damms (2) geneigt ist.

16. LED-Modul nach Anspruch 15,
wobei die Innenfläche (11) des äußeren Damms (2) an ihrem oberen Teil steiler ist.

17. LED-Modul nach einem der vorhergehenden Ansprüche,
wobei der äußere Damm (2) Siliciumdioxidpartikel umfasst.

## Revendications

1. Module LED comprenant une puce LED (1) montée sur une carte (4), et un couvercle,
- le couvercle comprenant un barrage extérieur (2) réparti sur la carte, et
- un remplissage central (3), qui est rempli dans le barrage extérieur (2),
dans lequel le barrage extérieur (2) est fabriqué à partir d'une résine, à base de silicone durcie,
dans lequel le remplissage central (3) est fabriqué à partir d'une résine transparente durcie, et
dans lequel le remplissage central (3) comprend une conversion de particules de couleurs, **caractérisé en ce que** le barrage extérieur (2) est non transparent et comprend des particules réfléchissantes, qui sont des pigments blancs faits de TiO₂, BaTiO₃, BaSO₄ et/ou ZrO₂, et
le remplissage central (3) est chimiquement lié au barrage extérieur (2) à travers l'interface située entre les deux matériaux.

2. Module LED selon la revendication 1,
dans lequel la résine du barrage extérieur (2) et le remplissage central (3) ont la même structure chimique.

3. Module LED selon la revendication 1,
dans lequel la résine du barrage extérieur (2) et le remplissage central (3) sont chimiquement identiques.

4. Module LED selon l'une quelconque des revendications précédentes,
dans lequel le barrage extérieur (2) comprend 10 à 60 % en poids de particules réfléchissantes.

5. Module LED selon l'une quelconque des revendications précédentes,
dans lequel la puce LED est montée sur la carte (4) suivant une technologie chip on board.

6. Module LED selon l'une quelconque des revendications précédentes,
dans lequel la paroi intérieure du barrage extérieur (2) est éloignée de la puce LED (1), la distance entre le barrage extérieur (2) et la puce LED (1) étant remplie avec le remplissage central (3).

7. Module LED selon l'une quelconque des revendications précédentes,
dans lequel le remplissage central (3) remplit tout le volume défini par le barrage extérieur (2).

8. Module LED selon l'une quelconque des revendications précédentes, dans lequel le barrage extérieur (2) est supérieur à la puce LED (1).

9. Module LED selon l'une quelconque des revendications précédentes,
dans lequel la hauteur du barrage extérieur (2) a au moins la hauteur de la puce LED (1) à couvrir.

10. Module LED selon l'une quelconque des revendications précédentes, dans lequel le barrage extérieur (2) a une forme circulaire, ovale ou rectangulaire.

11. Module LED selon l'une quelconque des revendications précédentes, comprenant une pluralité de puces LED (1),
dans lequel les puces LED (1) sont dans une configuration en rangée placée à l'intérieur du barrage extérieur (2).

12. Module LED selon l'une quelconque des revendications précédentes,
dans lequel le remplissage central (3) est réparti dans le barrage extérieur (2).

13. Module LED selon l'une quelconque des revendications précédentes comprenant des fils de connexion (5),
dans lequel les fils de connexion (5) sont entourés et stabilisés par le matériau du remplissage central (3).

14. Module LED selon l'une quelconque des revendications précédentes,
dans lequel la carte (4) est une carte plate (4) sans récessions.

15. Module LED selon l'une quelconque des revendications précédentes,
dans lequel la section transversale du barrage extérieur (2) devient plus étroit jusqu'au pic (10) du barrage extérieur (2) et
dans lequel la face intérieure (11) du barrage extérieur (2) est inclinée.

16. Module LED selon la revendication 15,
dans lequel la face intérieure (11) du barrage extérieur (2) est plus raide à sa partie supérieure.

17. Module LED selon l'une quelconque des revendications précédentes,
dans lequel le barrage extérieur (2) comprend des particules de silice.
